(19) Europäisches Patentamt / European Patent Office / Office européen des brevets

(11) EP 3 712 211 A1

(12) **EUROPEAN PATENT APPLICATION**
published in accordance with Art. 153(4) EPC

(43) Date of publication:
**23.09.2020 Bulletin 2020/39**

(21) Application number: **18877955.7**

(22) Date of filing: **15.11.2018**

(51) Int Cl.:
***C08L 83/06*** *(2006.01)* ***C08J 5/18*** *(2006.01)*
***C08K 3/00*** *(2018.01)* ***C08K 5/14*** *(2006.01)*
***C08L 83/05*** *(2006.01)* ***C08L 83/07*** *(2006.01)*
***H01L 23/36*** *(2006.01)* ***H01L 23/373*** *(2006.01)*

(86) International application number:
**PCT/JP2018/042337**

(87) International publication number:
**WO 2019/098290 (23.05.2019 Gazette 2019/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **17.11.2017 JP 2017222098**

(71) Applicant: **Fuji Polymer Industries Co., Ltd.**
**Nagoya-shi, Aichi 460-0012 (JP)**

(72) Inventor: **SUZUMURA Katsuyuki**
**Aichi 470-0533 (JP)**

(74) Representative: **Diehl & Partner**
**Patent- und Rechtsanwaltskanzlei mbB**
**Erika-Mann-Straße 9**
**80636 München (DE)**

# (54) TWO-STEP CURABLE THERMALLY CONDUCTIVE SILICONE COMPOSITION AND METHOD FOR PRODUCING SAME

(57) A two-step curable thermally conductive silicone composition includes a silicone component, thermally conductive particles, and a curing component. The silicone composition includes (A) 100 parts by weight of polyorganosiloxane, (B) 100 to 2500 parts by weight of thermally conducive particles with respect to the component A, (C) a platinum group metal catalyst as a curing catalyst for the polyorganosiloxane, and (D) 0.01 to 5 parts by weight of organic peroxide with respect to the component A. The silicone composition has been subjected to primary curing at a primary curing temperature and is capable of undergoing secondary curing at a temperature higher than the primary curing temperature. The silicone composition after the primary curing has a thermal conductivity of 0.2 to 17 W/m·K and an Asker C hardness of 5 to 80.

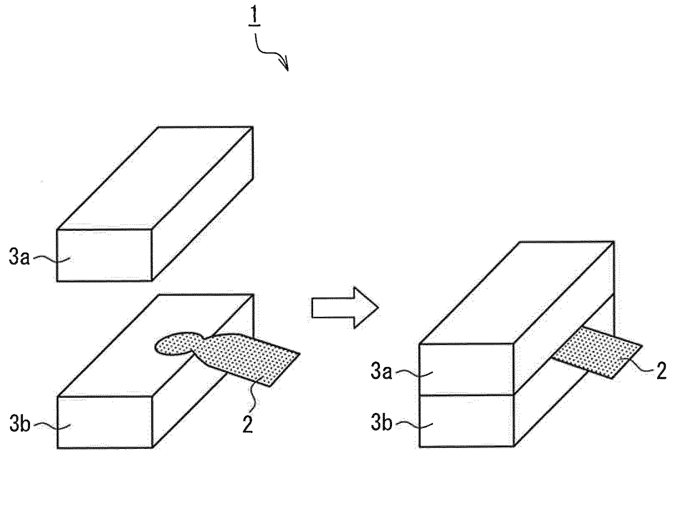


FIG. 1A



Printed by Jouve, 75001 PARIS (FR)

## Description

### Technical Field

The present invention relates to a thermally conductive resin composition used for thermally conductive components such as electronic components and a method for producing the same. More specifically, the present invention relates to a two-step curable thermally conductive silicone composition in which curing proceeds at different temperatures and a method for producing the same.

### Background Art

Semiconductors used in computers (CPUs), transistors, light-emitting diodes (LEDs), etc. generate heat during operation, and the performance of electronic components including them may be reduced by the heat. For this reason, a heat dissipating member is attached to a heat generating member such as a CPU in these electronic components. The heat dissipating member is often made of metal. Therefore, the adhesion of the heat dissipating member to the heat generating member is enhanced by inserting a sheet-like or gel-like thermally conductive composition between the heat generating member and the heat dissipating member, so that the heat transfer between them can be improved. Patent Document 1 proposes silicone rubber with low hardness and high impact resilience. The silicone rubber is obtained by pre-crosslinking polyorganosiloxane in the presence of a catalytic amount of a platinum group metal compound, and blending the pre-crosslinked product with an organic peroxide. Patent Document 2 proposes a surface printing layer formed on a base film. The surface printing layer is obtained by adding an ionic liquid to a material, primary vulcanizing the material, and secondary vulcanizing the resulting vulcanizate at a higher temperature than the primary vulcanization temperature.

### Prior Art Documents

### Patent Documents

Patent Document 1: JP 2005-68273 A
Patent Document 2: JP 2014-065272 A

### Disclosure of Invention

### Problem to be Solved by the Invention

Depending on the target product, when the thermally conductive composition is in the form of a sheet, the sheet is required to be soft before it is placed between the heat generating member and the heat dissipating member and to be cured by heat from the heat generating member after it is placed in the above position. However, there has been a problem that cannot be addressed by the conventional technology.
To solve the above conventional problem, the present invention provides a two-step curable thermally conductive silicone composition in which curing proceeds at different temperatures and a method for producing the same.

### Means for Solving Problem

A two-step curable thermally conductive silicone composition of the present invention includes a silicone component, thermally conductive particles, and a curing component. The silicone composition includes (A) 100 parts by weight of polyorganosiloxane, (B) 100 to 2500 parts by weight of thermally conducive particles with respect to the component A, (C) a platinum group metal catalyst as a curing catalyst for the polyorganosiloxane, and (D) 0.01 to 5 parts by weight of organic peroxide with respect to the component A. The silicone composition has been subjected to primary curing at a primary curing temperature and is capable of undergoing secondary curing at a temperature higher than the primary curing temperature. The silicone composition after the primary curing has a thermal conductivity of 0.2 to 17 W/m·K and an Asker C hardness of 5 to 80.
A method for producing a two-step curable thermally conductive silicone composition of the present invention provides the two-step curable thermally conductive silicone composition of the present invention. The method includes mixing the following components A to D, molding the mixture into a predetermined shape, and subjecting the molded product to primary curing at a primary curing temperature: (A) 100 parts by weight of polyorganosiloxane, (B) 100 to

2500 parts by weight of thermally conducive particles with respect to the component A, (C) a platinum group metal catalyst as a curing catalyst for the polyorganosiloxane, and (D) 0.01 to 5 parts by weight of organic peroxide with respect to the component A. The primary cured molded product is capable of undergoing secondary curing at a temperature higher than the primary curing temperature. The molded product after the primary curing has a thermal conductivity of 0.2 to 17 W/m·K and an Asker C hardness of 5 to 80.

A method for producing an electronic component of the present invention provides an electronic component including a heat generating member and a heat dissipating member. The method includes placing the two-step curable thermally conductive silicone composition of the present invention between the heat generating member and the heat dissipating member so that the silicone composition is in contact with both the heat generating member and the heat dissipating member, and subsequently subjecting the silicone composition to secondary curing by heating the silicone composition at a temperature higher than the primary curing temperature. The heating is performed by heat generated from the heat generating member.

Effects of the Invention

The present invention can provide a two-step curable thermally conductive silicone composition in which curing proceeds at different temperatures. The silicone composition includes the components A to D. The silicone composition has been subjected to primary curing at a primary curing temperature and is capable of undergoing secondary curing at a temperature higher than the primary curing temperature. The silicone composition after the primary curing has a thermal conductivity of 0.2 to 17 W/m·K and an Asker C hardness of 5 to 80. Thus, the two-step curable thermally conductive silicone composition of the present invention remains in the primary curing stage until it is placed between the heat generating member and the heat dissipating member. Moreover, the silicone composition is soft and easily inserted, e.g., between the heat generating member and the heat dissipating member. Once the silicone composition is placed between the heat generating member and the heat dissipating member, curing of the silicone composition proceeds to secondary curing, e.g., by heat from the heat generating member.

Brief Description of Drawings

[FIG. 1] FIGS. 1A to 1B are diagrams illustrating a method of measuring a thermal conductivity of a sample in an example of the present invention.

Description of the Invention

Curing of the two-step curable thermally conductive silicone composition of the present invention (which may also be referred to as "the silicone composition of the present invention" in the following) proceeds due to the curing action by the addition reaction using the platinum group metal catalyst at a primary curing temperature. Moreover, curing of the silicone composition of the present invention proceeds due to the curing action by the radical reaction using the organic peroxide at a secondary curing temperature that is higher than the primary curing temperature. In the silicone composition of the present invention, the platinum group metal catalyst and the organic peroxide are mixed together with the polyorganosiloxane and the thermally conductive particles. The mixture may be formed into, e.g., a sheet. The sheet-like silicone composition remains in the primary curing stage. A thermosetting resin material at this stage is usually called "B stage" or "half cure" type and is common with epoxy resin or the like. The sheet in this state is soft and easily inserted in the required position. In general, such sheets at the primary curing stage are shipped from the manufacturer, inserted in their required positions by customers, and then subjected to secondary curing by heat from the respective heat generating members.

The silicone composition of the present invention is prepared by using the components A to D preferably in the following amounts:

(A) 100 parts by weight of polyorganosiloxane;
(B) 100 to 2500 parts by weight of thermally conducive particles with respect to the component A;
(C) a platinum group metal catalyst as a curing catalyst for the polyorganosiloxane; and
(D) 0.01 to 5 parts by weight of organic peroxide with respect to the component A.

The polyorganosiloxane (A) is the principal material of an addition-curable silicone polymer and includes a base polymer component and a crosslinking agent component, as will be described later. The polyorganosiloxane (A) is usually separated into two parts, i.e., a solution A and a solution B for storage. For example, both the solution A and the solution B contain the base polymer component, the solution A further contains a curing catalyst such as a platinum group metal catalyst, and the solution B further contains the crosslinking agent component. The polyorganosiloxane (A)

is in this state when it is placed on the market. In general, the solution A, the solution B, the thermally conductive particles, and the organic peroxide are mixed, if necessary, with an additional platinum group metal catalyst, a coloring agent, and others. Then, the mixture is molded into, e.g., a sheet. The sheet-like molded product is subjected to primary curing. The curing is also referred to as crosslinking or vulcanization.

The two-step curable thermally conductive silicone composition of the present invention has been subjected to primary curing at a primary curing temperature and is capable of undergoing secondary curing at a temperature higher than the primary curing temperature. The thermal conductivity of the sheet after the primary curing is 0.2 to 17 W/m·K, preferably 0.5 to 15 W/m·K, and further preferably 1 to 10 W/m·K When the thermal conductivity is within the above range, heat from the heat generating member can be effectively transferred to the heat dissipating member. The Asker C hardness of the sheet after the primary curing is 5 to 80, preferably 10 to 75, and further preferably 15 to 70. When the Asker C hardness is within the above range, the sheet is soft and easily inserted in the required position.

The polyorganosiloxane used in the present invention preferably contains the following components for two-step curing:

(a) a base polymer component that is a linear organopolysiloxane having an average of two or more alkenyl groups per molecule, in which the alkenyl groups are bonded to silicon atoms at both ends of the molecular chain; and
(b) a crosslinking agent component that is an organohydrogenpolysiloxane having an average of two or more hydrogen atoms bonded to silicon atoms per molecule, in which the number of moles of the hydrogen atoms bonded to the silicon atoms is less than 1 mol with respect to 1 mol of the alkenyl groups bonded to the silicon atoms in the base polymer component.

The silicone composition of the present invention is preferably in the form of a sheet. The sheet-like silicone composition can easily be inserted between the heat generating member and the heat dissipating member.

In the present invention, a difference in the Asker C hardness between the silicone composition after the primary curing and the silicone composition after the secondary curing is preferably more than 12, and further preferably 15 or more. Thus, e.g., the sheet-like silicone composition at the primary curing stage is soft and easily inserted in the required position. After the sheet-like silicone composition is placed in the required position, it can be subjected to secondary curing by heat from the heat generating member and have a suitable hardness. The Asker C hardness of the sheet-like silicone composition after the secondary curing is preferably 40 or more, and further preferably 45 or more. This can improve the adhesion of the silicone composition of the present invention to the heat generating member and the heat dissipating member of an electronic component.

The method for producing a two-step curable thermally conductive silicone composition of the present invention includes mixing the following components A to D, molding the mixture into a predetermined shape such as a sheet, and subjecting the molded product to primary curing at a primary curing temperature (primary curing process): (A) 100 parts by weight of polyorganosiloxane, (B) 100 to 2500 parts by weight of thermally conducive particles with respect to the component A, (C) a platinum group metal catalyst as a curing catalyst for the polyorganosiloxane, and (D) 0.01 to 5 parts by weight of organic peroxide with respect to the component A. The two-step curable thermally conductive silicone composition (i.e., the primary cured molded product) is capable of undergoing secondary curing at a temperature higher than the primary curing temperature. The sheet after the primary curing has a thermal conductivity of 0.2 to 17 W/m·K and an Asker C hardness of 5 to 80.

The primary curing temperature is preferably 100°C or less, and the secondary curing temperature preferably exceeds the primary curing temperature. The primary curing temperature is further preferably in the range of room temperature (25°C) to 100°C. The secondary curing temperature is preferably in the range of 120°C to 170°C. The secondary curing temperature does not have to be maintained in this range. For example, the secondary curing may be performed as part of a heat cycle in the range of - 40°C to 170°C. Under these temperature conditions, the curing action by the addition reaction using the platinum group metal catalyst in the primary curing process and the curing action by the reaction using the organic peroxide in the secondary curing process can be performed efficiently.

Hereinafter, each component will be described.

(1) Base polymer component (component a in component A)

The base polymer component (component a) is an organopolysiloxane having two or more alkenyl groups bonded to silicon atoms per molecule. The organopolysiloxane containing two alkenyl groups is the base resin (base polymer component) of the silicone rubber composition of the present invention. In the organopolysiloxane, two alkenyl groups having 2 to 8 carbon atoms, and preferably 2 to 6 carbon atoms such as vinyl groups or allyl groups are bonded to the silicon atoms per molecule. The viscosity of the organopolysiloxane is preferably 10 to 1000000 mPa·s, and more preferably 100 to 100000 mPa·s at 25°C in terms of workability and curability.

Specifically, an organopolysiloxane expressed by the following general formula (1) is used. The organopolysiloxane has an average of two or more alkenyl groups per molecule, in which the alkenyl groups are bonded to silicon atoms at both ends of the molecular chain. The organopolysiloxane is a linear organopolysiloxane whose side chains are blocked with triorganosiloxy groups. The viscosity of the linear organopolysiloxane is preferably 10 to 1000000 mPa·s at 25°C in terms of workability and curability. Moreover, the linear organopolysiloxane may include a small amount of branched structure (trifunctional siloxane units) in the molecular chain.

[Chemical Formula 1]

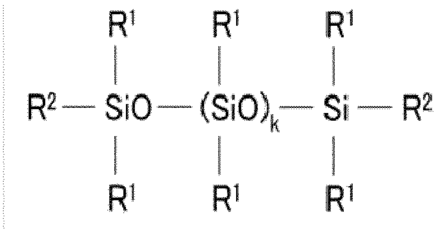

(1)

In the general formula (1), $R^1$ represents substituted or unsubstituted monovalent hydrocarbon groups that are the same as or different from each other and have no aliphatic unsaturated bond, $R^2$ represents alkenyl groups, and k represents 0 or a positive integer. The monovalent hydrocarbon groups represented by $R^1$ preferably have 1 to 10 carbon atoms, and more preferably 1 to 6 carbon atoms. Specific examples of the monovalent hydrocarbon groups include the following: alkyl groups such as methyl, ethyl, propyl, isopropyl, butyl, isobutyl, tert-butyl, pentyl, neopentyl, hexyl, cyclohexyl, octyl, nonyl, and decyl groups; aryl groups such as phenyl, tolyl, xylyl, and naphthyl groups; aralkyl groups such as benzyl, phenylethyl, and phenylpropyl groups; and substituted forms of these groups in which some or all hydrogen atoms are substituted by halogen atoms (fluorine, bromine, chlorine, etc.) or cyano groups, including halogen-substituted alkyl groups such as chloromethyl, chloropropyl, bromoethyl, and trifluoropropyl groups and cyanoethyl groups. The alkenyl groups represented by $R^2$ preferably have 2 to 6 carbon atoms, and more preferably 2 to 3 carbon atoms. Specific examples of the alkenyl groups include vinyl, allyl, propenyl, isopropenyl, butenyl, isobutenyl, hexenyl, and cyclohexenyl groups. In particular, the vinyl group is preferred. In the general formula (1), k is typically 0 or a positive integer satisfying $0 \leq k \leq 10000$, preferably $5 \leq k \leq 2000$, and more preferably $10 \leq k \leq 1200$.

The component a may also include an organopolysiloxane having three or more, typically 3 to 30, and preferably about 3 to 20, alkenyl groups bonded to silicon atoms per molecule. The alkenyl groups have 2 to 8 carbon atoms, and preferably 2 to 6 carbon atoms and can be, e.g., vinyl groups or allyl groups. The molecular structure may be a linear, ring, branched, or three-dimensional network structure. The organopolysiloxane is preferably a linear organopolysiloxane in which the main chain is composed of repeating diorganosiloxane units, and both ends of the molecular chain are blocked with triorganosiloxy groups. The viscosity of the linear organopolysiloxane is preferably 10 to 1000000 mPa·s, and more preferably 100 to 100000 mPa·s at 25°C.

Each of the alkenyl groups may be bonded to any part of the molecule. For example, the alkenyl group may be bonded to either a silicon atom that is at the end of the molecular chain or a silicon atom that is not at the end (but in the middle) of the molecular chain. In particular, a linear organopolysiloxane expressed by the following general formula (2) is preferred. The linear organopolysiloxane has 1 to 3 alkenyl groups on each of the silicon atoms at both ends of the molecular chain. In this case, however, if the total number of the alkenyl groups bonded to the silicon atoms at both ends of the molecular chain is less than 3, at least one alkenyl group is bonded to the silicon atom that is not at the end (but in the middle) of the molecular chain (e.g., as a substituent in the diorganosiloxane unit). As described above, the viscosity of the linear organopolysiloxane is preferably 10 to 1000000 mPa·s at 25°C in terms of workability and curability. Moreover, the linear organopolysiloxane may include a small amount of branched structure (trifunctional siloxane units) in the molecular chain.

[Chemical Formula 2]

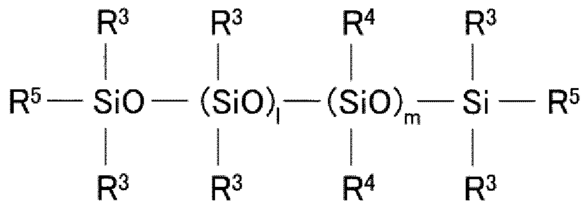

(2)

In the general formula (2), $R^3$ represents substituted or unsubstituted monovalent hydrocarbon groups that are the same as or different from each other, and at least one of them is an alkenyl group, $R^4$ represents substituted or unsubstituted monovalent hydrocarbon groups that are the same as or different from each other and have no aliphatic unsaturated bond, $R^5$ represents alkenyl groups, and l and m represent 0 or a positive integer. The monovalent hydrocarbon groups represented by $R^3$ preferably have 1 to 10 carbon atoms, and more preferably 1 to 6 carbon atoms. Specific examples of the monovalent hydrocarbon groups include the following: alkyl groups such as methyl, ethyl, propyl, isopropyl, butyl, isobutyl, tert-butyl, pentyl, neopentyl, hexyl, cyclohexyl, octyl, nonyl, and decyl groups; aryl groups such as phenyl, tolyl, xylyl, and naphthyl groups; aralkyl groups such as benzyl, phenylethyl, and phenylpropyl groups; alkenyl groups such as vinyl, allyl, propenyl, isopropenyl, butenyl, hexenyl, cyclohexenyl, and octenyl groups; and substituted forms of these groups in which some or all hydrogen atoms are substituted by halogen atoms (fluorine, bromine, chlorine, etc.) or cyano groups, including halogen-substituted alkyl groups such as chloromethyl, chloropropyl, bromoethyl, and trifluoropropyl groups and cyanoethyl groups.

The monovalent hydrocarbon groups represented by $R^4$ also preferably have 1 to 10 carbon atoms, and more preferably 1 to 6 carbon atoms. The monovalent hydrocarbon groups may be the same as the specific examples of $R^1$, but do not include an alkenyl group. The alkenyl groups represented by $R^5$ preferably have 2 to 6 carbon atoms, and more preferably 2 to 3 carbon atoms. Specific examples of the alkenyl groups are the same as those of $R^2$ in the general formula (1), and the vinyl group is preferred.

In the general formula (2), l and m are typically 0 or positive integers satisfying $0 < 1 + m \leq 10000$, preferably $5 \leq l + m \leq 2000$, and more preferably $10 \leq l + m \leq 1200$. Moreover, l and m are integers satisfying $0 < l/(l + m) \leq 0.2$, and preferably $0.0011 \leq l/(l + m) \leq 0.1$.

(2) Crosslinking agent component (component b in component A)

The component b is an organohydrogenpolysiloxane that acts as a crosslinking agent. The addition reaction (hydrosilylation) between SiH groups in the component b and alkenyl groups in the base polymer component produces a cured product. Any organohydrogenpolysiloxane that has two or more hydrogen atoms (i.e., SiH groups) bonded to silicon atoms per molecule may be used. The molecular structure of the organohydrogenpolysiloxane may be a linear, ring, branched, or three-dimensional network structure. The number of silicon atoms in a molecule (i.e., the degree of polymerization) may be 2 to 1000, and preferably about 2 to 300.

The locations of the silicon atoms to which the hydrogen atoms are bonded are not particularly limited. The silicon atoms may be either at the ends or not at the ends (but in the middle) of the molecular chain. The organic groups bonded to the silicon atoms other than the hydrogen atoms may be, e.g., substituted or unsubstituted monovalent hydrocarbon groups that have no aliphatic unsaturated bond, which are the same as those of $R^1$ in the general formula (1).

The structures expressed by the following general formulas (3) to (5) can be given as examples of the organohydrogenpolysiloxane of the component b.

[Chemical Formula 3]

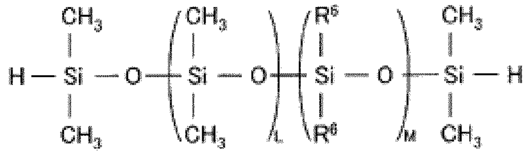

(3)

[Chemical Formula 4]

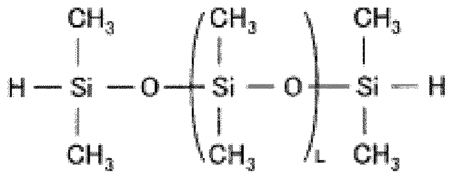

(4)

[Chemical Formula 5]

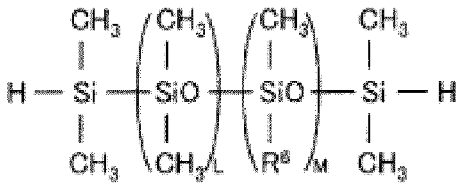

(5)

In these general formulas, $R^6$ represents organic groups including at least one of phenyl, epoxy, acryloyl, methacryloyl, and alkoxy groups, L is an integer of 0 to 1000, and preferably 0 to 300, and M is an integer of 1 to 200.

(3) Thermally conductive particles (component B)

The thermally conductive particles of the component B are also referred to as a thermally conductive filler. The thermally conductive particles are preferably added in an amount of 100 to 2500 parts by weight with respect to 100 parts by weight of the component A (matrix component). The addition of the thermally conductive particles can maintain a high thermal conductivity. The thermally conductive particles are preferably composed of at least one selected from alumina, zinc oxide, magnesium oxide, aluminum nitride, boron nitride, aluminum hydroxide, and silica. The thermally conductive particles may have various shapes such as spherical, scaly, and polyhedral. When alumina is used, $\alpha$-alumina with a purity of 99.5 wt% or more is preferred. The specific surface area of the thermally conductive particles is preferably 0.06 to 10 $m^2/g$. The specific surface area is a BET specific surface area and is measured in accordance with JIS R 1626. The average particle size of the thermally conductive particles is preferably 0.1 to 100 $\mu m$. The average particle size may be measured with a laser diffraction scattering method to determine D50 (median diameter). The method may use, e.g., a laser diffraction/scattering particle size distribution analyzer LA-950 S2 manufactured by HORIBA, Ltd.

The thermally conductive particles preferably include at least two types of inorganic particles with different average particle sizes. This is because small-size inorganic particles fill the spaces between large-size inorganic particles, which can provide nearly the closest packing and improve the thermal conductivity.

It is preferable that the inorganic particles are surface treated with a silane compound or its partial hydrolysate. The silane compound is expressed by $R(CH_3)_aSi(OR')_{3-a}$, where R represents a substituted or unsubstituted organic group having 1 to 20 carbon atoms, R' represents an alkyl group having 1 to 4 carbon atoms, and a is 0 or 1. Examples of an alkoxysilane compound (simply referred to as "silane" in the following) expressed by $R(CH_3)_aSi(OR')_{3-a}$, where R represents a substituted or unsubstituted organic group having 1 to 20 carbon atoms, R' represents an alkyl group having 1 to 4 carbon atoms, and a is 0 or 1, include the following: methyltrimethoxysilane; ethyltrimethoxysilane; propyltrimethoxysilane; butyltrimethoxysilane; pentyltrimethoxysilane; hexyltrimethoxysilane; hexyltriethoxysilane; octyltrimethoxysilane; octyltriethoxysilane; decyltrimethoxysilane; decyltriethoxysilane; dodecyltrimethoxysilane; dodecyltriethoxysilane; hexadodecyltrimethoxysilane; hexadodecyltriethoxysilane; octadecyltrimethoxysilane; and octadecyltriethoxysilane. These silane compounds may be used individually or in combinations of two or more. The alkoxysilane and one-end silanol siloxane may be used together as the surface treatment agent. In this case, the surface treatment may include adsorption in addition to a covalent bond. It is preferable that the inorganic particles with an average particle size of 2 $\mu m$ or more are added in an amount of at least "(100 $\times$ specific surface area) / minimum covering area of surface treatment agent" when the total amount of the inorganic particles is 100 parts by weight.

(4) Platinum group metal catalyst (component C)

The platinum group metal catalyst of the component C is a component that accelerates the first stage curing of the composition including the components A to D. The component C may be a catalyst used for a hydrosilylation

reaction. Examples of the catalyst include platinum group metal catalysts such as platinum-based, palladium-based, and rhodium-based catalysts. The platinum-based catalysts include, e.g., platinum black, platinum chloride, chloroplatinic acid, a reaction product of chloroplatinic acid and monohydric alcohol, a complex of chloroplatinic acid and olefin or vinylsiloxane, and platinum bisacetoacetate. The component C may be mixed in an amount necessary for curing the component A, and preferably in an amount capable of sufficiently curing the component A. The amount of the component C can be appropriately adjusted in accordance with the desired curing rate or the like. The platinum group metal catalyst is usually contained in the silicone component (e.g., a two-part room temperature curing silicone polymer) used in the production of the silicone composition of the present invention. Further, to sufficiently cure the component A, an additional platinum group metal catalyst may be mixed with the silicone component in the production of the silicone composition of the present invention. The amount of the platinum group metal catalyst is preferably 0.01 to 1000 ppm expressed in terms of the weight of metal atoms with respect to the component A.

When the platinum group metal catalyst is in "an amount capable of sufficiently curing the component A," the Asker C hardness of the primary cured product can be in the range of 5 to 80.

(5) Organic peroxide (component D)

The component D is a curing component that accelerates the second stage curing of the composition including the components A to D. The component D is an organic peroxide. The component D generates radicals when heated, causing a crosslinking reaction of the component A. Examples of the component D include the following: acyl peroxides such as benzoyl peroxide and bis(p-methylbenzoyl) peroxide; alkyl peroxides such as di-tert-butyl peroxide, 2,5-dimethyl-2,5-di(tert-butylperoxy)hexane, tert-butyl cumyl peroxide, and dicumyl peroxide; and ester-based organic peroxides such as tert-butyl perbenzoate. The amount of the component D is prefrably 0.01 to 5 parts by weight, and more preferably 0.1 to 4 parts by weight with respect to 100 parts by weight of the component A.

(6) Other components

The silicone composition of the present invention may include components other than the above as needed. For example, the silicone composition may include an inorganic pigment such as colcothar, and alkyltrialkoxysilane used, e.g., for the surface treatment of a filler. Moreover, alkoxy group-containing silicone may be added, e.g., for the surface treatment of a filler.

The present invention also can provide a method for producing an electronic component as follows.

The method for producing an electronic component of the present invention includes placing the silicone composition of the present invention between the heat generating member and the heat dissipating member so that the silicone composition is in contact with both the heat generating member and the heat dissipating member, and subsequently subjecting the silicone composition to secondary curing (secondary curing process) by heating the silicone composition (i.e., the primary cured molded product) at a temperature higher than the primary curing temperature. The secondary curing may be performed by heat generated from the heat generating member. The heat generating member and the heat dissipating member have been conventionally known. In many cases, the heat generating member may be a semiconductor used in computers (CPUs), transistors, light-emitting diodes (LEDs), etc. and the heat dissipating member may be metal.

Examples

Hereinafter, the present invention will be described by way of examples. However, the present invention is not limited to the following examples. Various parameters were measured in the following manner.

<Thermal conductivity>

The thermal conductivity of the primary cured product of a thermally conductive silicone rubber sheet was measured by a hot disk (in accordance with ISO/CD 22007-2). As shown in FIG. 1A, using a thermal conductivity measuring apparatus 1, a polyimide film sensor 2 was sandwiched between two samples (primary cured products) 3a, 3b, and constant power was applied to the sensor 2 to generate a certain amount of heat. Then, the thermal characteristics were analyzed from a temperature rise value of the sensor 2. The sensor 2 has a tip 4 with a diameter of 7 mm. The tip 4 has a double spiral structure of electrodes. Moreover, an electrode 5 for an applied current and an electrode 6 for a resistance value (temperature measurement electrode) are located on the lower portion of the sensor 2. The thermal conductivity was calculated by the following formula (1).

[Formula 1]

$$\lambda = \frac{P_0 \cdot D(\tau)}{\pi^{3/2} \cdot r} \cdot \frac{D(\tau)}{\Delta T(\tau)}$$

| | |
|---|---|
| $\lambda$: | Thermal conductivity (W/m·K) |
| $P_0$: | Constant power (W) |
| r: | Radius of sensor (m) |
| $\tau$: | $\sqrt{\alpha \cdot t / r^2}$ |
| $\alpha$: | Thermal diffusivity of sample ($m^2/s$) |
| t: | Measuring time (s) |
| $D(\tau)$: | Dimensionless function of $\tau$ |
| $\Delta T(\tau)$: | Temperature rise of sensor (K) |

<Hardness>

The Asker C hardness of the primary cured product and the secondary cured product of the thermally conductive silicone rubber sheet was measured.

<Adhesive breaking load, tensile shear strength>

The adhesive strength of the secondary cured thermally conductive silicone rubber sheet was measured by a method in accordance with JIS K 6850. The specific measurement conditions were as follows.

[Measurement conditions]

Measuring device: Autograph AGS-X manufactured by SHIMADZU CORPORATION
Sample size: primary cured thermally conductive silicone rubber sheet of 12.5 mm × 25 mm × 0.25 mm
Test piece: A pair of aluminum alloy plates bonded together with the above sample was used as a test piece.
Bonding conditions: The pair of aluminum alloy plates and the primary cured thermally conductive silicone rubber sheet adhered closely to each other by applying a pressure of about 6 MPa to the bonded portion of the test piece. Then, the test piece was heated at 150°C for 10 hours to cause secondary curing.
Test conditions: test speed of 1 mm/min
The maximum value (N) of the test force was taken as an adhesive breaking load (i.e., a load at the breaking point), and the value obtained by dividing the adhesive breaking load by the adhesive area (12.5 mm × 25 mm) was a tensile shear strength (MPa). Table 4 shows the results.

(Examples 1 to 3, Comparative Example 1)

1. Material components

(1) Polyorganosiloxane (component A)

A two-part room temperature curing silicone polymer (silicone component) containing polyorganosiloxane was used. One solution (solution A) contained a base polymer component (i.e., the component a in the component A) and a platinum group metal catalyst. The other solution (solution B) contained a base polymer component (i.e., the component a in the component A) and an organohydrogenpolysiloxane which is a crosslinking agent component (i.e., the component b in the component A).

(2) Thermally conductive particles (component B)

Three types of alumina particles shown in Table 1 were used. Then, 1% by mass of a silane coupling agent (octyltriethoxysilane) was added to the alumina particles and stirred uniformly. The stirred alumina particles were spread uniformly over, e.g., a tray and dried at 100°C for 2 hours. Thus, the alumina particles were surface treated. This surface treatment prevented a reduction in the acceleration of curing that is the catalytic ability of the Pt catalyst. In this case,

the average particle size means D50 (median diameter) in a volume-based cumulative particle size distribution, which is determined by a particle size distribution measurement with a laser diffraction scattering method. The measuring device may be, e.g., a laser diffraction/scattering particle size distribution analyzer LA-950 S2 manufactured by HORIBA, Ltd. The alumina particles (1) had an average particle size of 0.3 μm and a specific surface area of 7.0 $m^2/g$. The alumina particles (2) had an average particle size of 2 μm and a specific surface area of 1.0 $m^2/g$. The alumina particles (3) had an average particle size of 35 μm and a specific surface area of 0.2 $m^2/g$.

(3) Platinum group metal catalyst (component C)

A platinum-vinyldisiloxane complex was used as an additional platinum group metal catalyst.

As described above, the two-part room temperature curing silicone polymer (silicone component) contained the platinum group metal catalyst. In the preparation of the silicone compositions of Examples 1 to 3 and Comparative Example 1, the additional platinum group metal catalyst was added in an amount of 3 parts by weight with respect to 100 parts by weight of the silicone component so that the polyorganosiloxane was fully subjected to primary curing. In the silicone compositions of Examples 1 to 3 and Comparative Example 1, the amount of the platinum group metal catalyst was 0.01 to 1000 ppm expressed in terms of the weight of metal atoms with respect to the total amount of the polyorganosiloxane and the platinum group metal catalyst.

(4) Organic peroxide (component D)

An alkyl peroxide was used as an organic peroxide.

2. Compound

Each of the materials was weighed in the amount as shown in Table 1. Then, the materials were placed in a kneader to form a compound.

Table 1 indicates the amount of each material (parts by weight) with respect to 100 parts by mass of the silicone component (two-part room temperature curing silicone polymer). In all the compounds, the amounts of the thermally conductive particles, the organic peroxide, and other components added to 100 parts by mass of the polyorganosiloxane satisfy their respective preferred amounts of the present invention, as described above.

3. Sheet forming process

The compound was sandwiched between polyester films that had been subjected to a release treatment. The layered material was formed into a sheet with a thickness of 2.0 mm by constant speed rolls. Subsequently, the sheet was heated and cured at 100°C for 10 minutes, resulting in a thermally conductive silicone rubber sheet. The thermally conductive silicone rubber sheet was subjected to secondary curing at 170°C for 12 hours. Table 1 shows the physical properties of the thermally conductive silicone rubber sheet.

[TABLE 1]

<table>
<tr><th>Table 1</th><th colspan="2">Material name</th><th>Comparative Example 1</th><th>Example 1</th><th>Example 2</th><th>Example 3</th></tr>
<tr><td rowspan="7">Silicone composition</td><td colspan="2">Silicone component (parts by weight)</td><td>100</td><td>100</td><td>100</td><td>100</td></tr>
<tr><td colspan="2">Platinum group metal catalyst (parts by weight)</td><td>3</td><td>3</td><td>3</td><td>3</td></tr>
<tr><td colspan="2">Organic peroxide (parts by weight)</td><td>0</td><td>0.05</td><td>0.15</td><td>0.25</td></tr>
<tr><td rowspan="3">Thermally conductive particles</td><td>Alumina particles (1) (parts by weight)</td><td>240</td><td>240</td><td>240</td><td>240</td></tr>
<tr><td>Alumina particles (2) (parts by weight)</td><td>480</td><td>480</td><td>480</td><td>480</td></tr>
<tr><td>Alumina particles (3) (parts by weight)</td><td>780</td><td>780</td><td>780</td><td>780</td></tr>
<tr><td>Others</td><td>Pigment (colcothar) (parts by weigh)</td><td>4</td><td>4</td><td>4</td><td>4</td></tr>
</table>

(continued)

| Table 1 | Material name | | Comparative Example 1 | Example 1 | Example 2 | Example 3 |
|---|---|---|---|---|---|---|
| Evaluation | | Primary curing conditions | 100°C | 100°C | 100°C | 100°C |
| | | | 10 min | 10 min | 10 min | 10 min |
| | | Hardness of primary cured product (Asker C) | 20 | 20 | 21 | 20 |
| | | Secondary curing conditions | 170°C | 170°C | 170°C | 170°C |
| | | | 12 hr | 12 hr | 12 hr | 12 hr |
| | | Hardness of secondary cured product (Asker C) | 31 | 49 | 74 | 81 |
| | | Thermal conductivity of primary cured product (W/m·K) | 4.5 | 4.5 | 4.5 | 4.5 |

As can be seen from Table 1, the thermally conductive silicone rubber sheets of Examples 1 to 3 included both the platinum group metal catalyst and the organic peroxide. Thus, the thermally conductive silicone rubber sheets had been subjected to primary curing at a primary curing temperature and were capable of undergoing secondary curing at a temperature higher than the primary curing temperature. The primary cured sheets of Examples 1 to 3 had a thermal conductivity of 4.5 W/m·K and an Asker C hardness of 20 to 21. On the other hand, the thermally conductive silicone rubber sheet of Comparative Example 1 did not include an organic peroxide. Therefore, the hardness of the thermally conductive silicone rubber sheet after the secondary curing (secondary cured product) of Comparative Example 1 was not as high as that of the sheets of Examples 1 to 3. If the hardness is not high, the curing is insufficient and the rubber strength is not increased, so that the tensile shear strength is reduced.

(Examples 4 to 8, Reference Examples 1 to 2)

Compounds were prepared in the same manner as Example 1 except that a titanium oxide with an average particle size of 0.3 μm was used as a heat-resistant aid, and the amounts of the additional platinum group metal catalyst, the thermally conductive particles, and the pigment (colcothar) were as shown in Tables 2 to 3, respectively. The experiments were performed in the same manner as Example 1 except that the thermally conductive silicone rubber sheets were subjected to primary curing and secondary curing under the curing conditions shown in Tables 2 to 3.

Tables 2 and 3 indicate the amount of each material (parts by weight) with respect to 100 parts by mass of the silicone component (two-part room temperature curing silicone polymer). In all the compounds, the amounts of the thermally conductive particles, the organic peroxide, and other components added to 100 parts by mass of the polyorganosiloxane satisfy their respective preferred amounts of the present invention, as described above.

As described above, the two-part room temperature curing silicone polymer (silicone component) contained the platinum group metal catalyst. In the preparation of the silicone compositions of Examples 4 to 8 and Reference Examples 1 to 2, the additional platinum group metal catalyst was added in an amount of 4 parts by weight with respect to 100 parts by weight of the silicone component so that the polyorganosiloxane was fully subjected to primary curing. In the silicone compositions of Examples 4 to 8 and Reference Examples 1 to 2, the amount of the platinum group metal catalyst was 0.01 to 1000 ppm expressed in terms of the weight of metal atoms with respect to the total amount of the polyorganosiloxane and the platinum group metal catalyst.

[TABLE 2]

| Table 2 | Material name | | Example 4 | Example 5 | Example 6 | Example 7 | Example 8 |
|---|---|---|---|---|---|---|---|
| Silicone composition | Silicone component | | 100 | 100 | 100 | 100 | 100 |
| | Platinum group metal catalyst (parts by weight) | | 4 | 4 | 4 | 4 | 4 |
| | Organic peroxide (parts by weight) | | 0.05 | 0.05 | 0.05 | 0.05 | 0.05 |
| | Thermally conductive particles | Alumina particles (1) (parts by weight) | 110 | 110 | 110 | 110 | 110 |
| | | Alumina particles (2) (parts by weight) | 450 | 450 | 450 | 450 | 450 |
| | | Alumina particles (3) (parts by weight) | 1000 | 1000 | 1000 | 1000 | 1000 |
| | Others | Pigment (colcothar) (parts by weigh) | 1 | 1 | 1 | 1 | 1 |
| | | Heat-resistant aid ($TiO_2$) (parts by weight) | 2 | 2 | 2 | 2 | 2 |
| Evaluation | | Primary curing conditions | 100°C | 100°C | 100°C | 100°C | 100°C |
| | | | 10 min | 10 min | 10 min | 10 min | 10 min |
| | | Hardness of primary cured product (Asker C) | 27 | 27 | 27 | 27 | 27 |
| | | Secondary curing conditions | 120°C | 150°C | 165°C | 180°C | 200°C |
| | | | 24 hr | 24 hr | 24 hr | 24 hr | 24 hr |
| | | Hardness of secondary cured product (Asker C) | 41 | 43 | 42 | 50 | 71 |
| | | Thermal conductivity of primary cured product (W/m·K) | 4.5 | 4.5 | 4.5 | 4.5 | 4.5 |

[TABLE 3]

| Table 3 | Material name | | Reference Example 1 | Reference Example 2 |
|---|---|---|---|---|
| Silicone composition | Silicone component | | 100 | 100 |
| | Platinum group metal catalyst (parts by weight) | | 4 | 4 |
| | Organic peroxide (parts by weight) | | 0.05 | 0.05 |
| | Thermally conductive particles | Alumina particles (1) (parts by weight) | 110 | 110 |
| | | Alumina particles (2) (parts by weight) | 450 | 450 |
| | | Alumina particles (3) (parts by weight) | 1000 | 1000 |
| | Others | Pigment (colcothar) (parts by weigh) | 1 | 1 |
| | | Heat-resistant aid ($TiO_2$) (parts by weight) | 2 | 2 |
| Evaluation | | Primary curing conditions | 100°C | 100°C |
| | | | 10 min | 10 min |
| | | Hardness of primary cured product (Asker C) | 25 | 29 |
| | | Secondary curing conditions | 70°C | 100°C |
| | | | 24 hr | 24 hr |
| | | Hardness of secondary cured product (Asker C) | 27 | 37 |
| | | Thermal conductivity of primary cured product (W/m·K) | 4.5 | 4.5 |

As can be seen from Tables 2 to 3, the thermally conductive silicone rubber sheets of Examples 4 to 8 included both the platinum group metal catalyst and the organic peroxide. Thus, the thermally conductive silicone rubber sheets had been subjected to primary curing at a primary curing temperature and were capable of undergoing secondary curing at a temperature higher than the primary curing temperature. The primary cured sheets of Examples 4 to 8 had a thermal conductivity of 4.5 W/m·K and an Asker C hardness of 27. On the other hand, in Reference Examples 1 to 2, since the secondary curing temperature was the same as or lower than the primary curing temperature, the hardness of the secondary cured product was not as high as that of the sheets of Examples 4 to 8.

(Examples 9 to 10, Comparative Examples 2 to 3)

The experiments were performed in the same manner as Example 1 except that each of the materials was weighed in the amount as shown in Table 4, the materials were placed in a kneader to form a compound, and then a thermally conductive silicone rubber sheet was cured under the curing conditions shown in Table 4. The alumina particles (4) had an average particle size of 75 $\mu$m and a specific surface area of 0.2 $m^2$/g.

In the preparation of the silicone compositions of Examples 9 to 10 and Comparative Examples 2 to 3, no additional platinum group metal catalyst was added and only the platinum group metal catalyst contained in the silicone component (two-part room temperature curing silicone polymer) was used. The polyorganosiloxane was fully subjected to primary curing solely with the platinum group metal catalyst contained in the silicone component. In the silicone compositions of Examples 9 to 10 and Comparative Examples 2 to 3, the amount of the platinum group metal catalyst was 0.01 to 1000 ppm expressed in terms of the weight of metal atoms with respect to the total amount of the polyorganosiloxane and the platinum group metal catalyst.

Table 4 indicates the amount of each material (parts by weight) with respect to 100 parts by mass of the silicone component (two-part room temperature curing silicone polymer). In all the compounds, the amounts of the thermally

conductive particles, the organic peroxide, and other components added to 100 parts by mass of the polyorganosiloxane satisfy their respective preferred amounts of the present invention, as described above.

[TABLE 4]

| Table 4 | Material name | | Comparative Example 2 | Example 9 | Comparative Example 3 | Example 10 |
|---|---|---|---|---|---|---|
| Silicone composition | Silicone component | | 100 | 100 | 100 | 100 |
| | Organic peroxide (parts by weight) | | absence | 0.3 | absence | 0.3 |
| | Thermally conductive particles | Alumina particles (2) (parts by weight) | 400 | 400 | 400 | 400 |
| | | Alumina particles (3) (parts by weight) | 220 | 220 | 220 | 220 |
| | | Alumina particles (4) (parts by weight) | 90 | 90 | 90 | 90 |
| Evaluation | | Primary curing conditions | 100°C | 100°C | 100°C | 100°C |
| | | | 10 min | 10 min | 10 min | 10 min |
| | | Hardness of primary cured product (Asker C) | 15 | 8 | 35 | 35 |
| | | Secondary curing conditions | 150°C | 150°C | 150°C | 150°C |
| | | | 10 hr | 10 hr | 10 hr | 10 hr |
| | | Hardness of secondary cured product (Asker C) | 20 | 60 | 38 | 85 |
| | | Thermal conductivity of primary cured product (W/m·K) | 1.8 | 1.8 | 1.8 | 1.8 |
| | | Adhesive breaking load (N) | 55 | 197 | 103 | 179 |
| | | Tensile shear strength (Mpa) | 0.18 | 0.63 | 0.33 | 0.57 |

As can be seen from Table 4, the thermally conductive silicone rubber sheets of Examples 9 to 10 included both the platinum group metal catalyst and the organic peroxide. Thus, the thermally conductive silicone rubber sheets had been subjected to primary curing at a primary curing temperature and were capable of undergoing secondary curing at a temperature higher than the primary curing temperature. The primary cured sheets of Examples 9 to 10 had a thermal conductivity of 1.8 W/m·K and an Asker C hardness of 8 to 35. The adhesive strength was higher in Examples 9 to 10 than in Comparative Examples 2 to 3. On the other hand, the thermally conductive silicone rubber sheets of Comparative Examples 2 to 3 did not include an organic peroxide. Therefore, the hardness of the thermally conductive silicone rubber sheets after the secondary curing (secondary cured products) of Comparative Examples 2 to 3 was not as high as that of the sheets of Examples 1 to 3.

Industrial Applicability

The two-step curable thermally conductive silicone composition of the present invention can be applied to products in various forms such as a sheet that is interposed between the heat generating member and the heat dissipating member of a heat generating component.

Description of Reference Numerals

| | |
|---|---|
| 1 | Thermal conductivity measuring apparatus |
| 2 | Sensor |
| 3a, 3b | Sample |
| 4 | Tip of the sensor 2 |
| 5 | Electrode for applied current |
| 6 | Electrode for resistance value (temperature measurement electrode) |

## Claims

1. A two-step curable thermally conductive silicone composition comprising a silicone component, thermally conductive particles, and a curing component,
wherein the silicone composition includes

   (A) 100 parts by weight of polyorganosiloxane,
   (B) 100 to 2500 parts by weight of thermally conducive particles with respect to the component A,
   (C) a platinum group metal catalyst as a curing catalyst for the polyorganosiloxane, and
   (D) 0.01 to 5 parts by weight of organic peroxide with respect to the component A,
   the silicone composition has been subjected to primary curing at a primary curing temperature and is capable of undergoing secondary curing at a temperature higher than the primary curing temperature, and
   the silicone composition after the primary curing has a thermal conductivity of 0.2 to 17 W/m·K and an Asker C hardness of 5 to 80.

2. The two-step curable thermally conductive silicone composition according to claim 1, wherein an amount of the platinum group metal catalyst is 0.01 to 1000 ppm expressed in terms of a weight of metal atoms with respect to the component A.

3. The two-step curable thermally conductive silicone composition according to claim 1 or 2, wherein the polyorganosiloxane contains the following components:

   (a) a base polymer component that is a linear organopolysiloxane having an average of two or more alkenyl groups per molecule, in which the alkenyl groups are bonded to silicon atoms at both ends of a molecular chain; and
   (b) a crosslinking agent component that is an organohydrogenpolysiloxane having an average of two or more hydrogen atoms bonded to silicon atoms per molecule, in which the number of moles of the hydrogen atoms bonded to the silicon atoms is less than 1 mol with respect to 1 mol of the alkenyl groups bonded to the silicon atoms in the base polymer component.

4. The two-step curable thermally conductive silicone composition according to any one of claims 1 to 3, wherein the silicone composition is in the form of a sheet.

5. The two-step curable thermally conductive silicone composition according to any one of claims 1 to 4, wherein the primary curing is performed by an addition reaction using the platinum group metal catalyst and the secondary curing is performed by a reaction using the peroxide.

6. The two-step curable thermally conductive silicone composition according to any one of claims 1 to 5, wherein the silicone composition after the secondary curing has an Asker C hardness of 40 or more.

7. A method for producing the two-step curable thermally conductive silicone composition according to any one of claims 1 to 6,
the method comprising:

   mixing the following components A to D;
   molding the mixture into a predetermined shape; and
   subjecting the molded product to primary curing at a primary curing temperature:

      (A) 100 parts by weight of polyorganosiloxane,
      (B) 100 to 2500 parts by weight of thermally conducive particles with respect to the component A,

(C) a platinum group metal catalyst as a curing catalyst for the polyorganosiloxane, and
(D) 0.01 to 5 parts by weight of organic peroxide with respect to the component A,

wherein the primary cured molded product is capable of undergoing secondary curing at a temperature higher than the primary curing temperature, and
the molded product after the primary curing has a thermal conductivity of 0.2 to 17 W/m·K and an Asker C hardness of 5 to 80.

**8.** The method according to claim 7, wherein an amount of the platinum group metal catalyst is 0.01 to 1000 ppm expressed in terms of a weight of metal atoms with respect to the component A.

**9.** The method according to claim 7 or 8, wherein the primary curing temperature is 100°C or less, and the secondary curing temperature exceeds the primary curing temperature.

**10.** A method for producing an electronic component including a heat generating member and a heat dissipating member, the method comprising:

placing the two-step curable thermally conductive silicone composition according to any one of claims 1 to 6 between the heat generating member and the heat dissipating member so that the silicone composition is in contact with both the heat generating member and the heat dissipating member; and
subsequently subjecting the silicone composition to secondary curing by heating the silicone composition at a temperature higher than the primary curing temperature,
wherein the heating is performed by heat generated from the heat generating member.

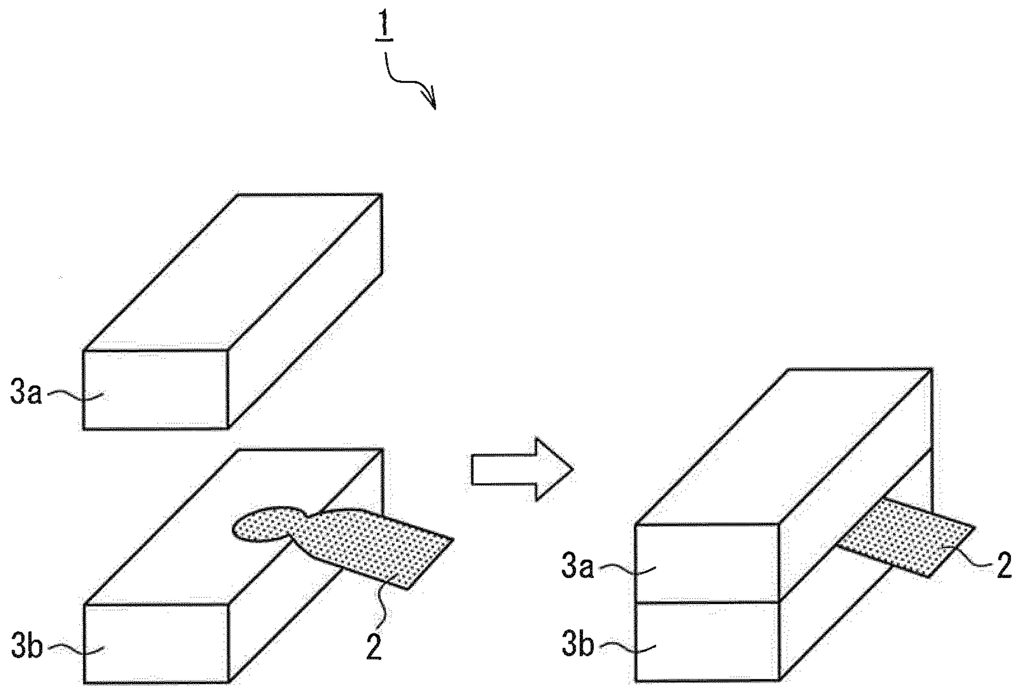


FIG. 1A

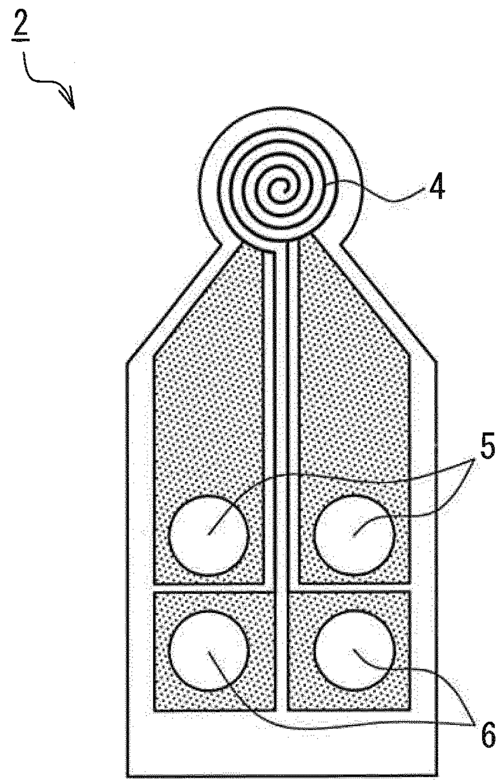


FIG. 1B

## INTERNATIONAL SEARCH REPORT

International application No.
PCT/JP2018/042337

A. CLASSIFICATION OF SUBJECT MATTER
Int.Cl. C08L83/06(2006.01)i, C08J5/18(2006.01)i, C08K3/00(2018.01)i, C08K5/14(2006.01)i, C08L83/05(2006.01)i, C08L83/07(2006.01)i, H01L23/36(2006.01)i, H01L23/373(2006.01)i

According to International Patent Classification (IPC) or to both national classification and IPC

B. FIELDS SEARCHED

Minimum documentation searched (classification system followed by classification symbols)
Int.Cl. C08L83/06, C08J5/18, C08K3/00, C08K5/14, C08L83/05, C08L83/07, H01L23/36, H01L23/373

Documentation searched other than minimum documentation to the extent that such documents are included in the fields searched

| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2017-075218 A (SHIN-ETSU CHEMICAL CO., LTD.) 20 April 2017, claims 1-2, paragraphs [0001], [0017]-[0034], [0038]-[0054] & US 2017/0107415 A1, claim 3 & EP 3156457 A1 & KR 10-2017-0044041 A & CN 106905698 A | 1-9<br>10 |
| Y | JP 2010-013521 A (SHIN-ETSU CHEMICAL CO., LTD.) 21 January 2010, paragraphs [0002]-[0003], [0028] (Family: none) | 10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 30 January 2019 (30.01.2019) | 12 February 2019 (12.02.2019) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2018/042337

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2013-147600 A (SHIN-ETSU CHEMICAL CO., LTD.) 01 August 2013, claims 1, 6-7, paragraphs [0001], [0057], [0060]-[0080] & CN 103214853 A, claim 1 | 1-10 |
| Y | WO 2016/160750 A1 (ROGERS CORPORATION) 06 October 2016, claims 1, 18, paragraphs [0002], [0005] & JP 2018-510240 A & US 2018/0118939 A1 & GB 2550755 A & CN 107531997 A & KR 10-2017-0133414 A | 1-10 |
| A | WO 2016/103654 A1 (DOW CORNING TORAY CO., LTD.) 30 June 2016, claims 1-2, 11, paragraphs [0124]-[0144], example 3 & US 2017/0355804 A1, paragraph [0238] | 1-10 |
| A | JP 05-140456 A (SHIN-ETSU CHEMICAL CO., LTD.) 08 June 1993, claim 1, paragraphs [0011], [0014]-[0018], [0025]-[0042] (Family: none) | 1-10 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005068273 A
- JP 2014065272 A